# EUROPÄISCHE PATENTANMELDUNG

(11) **EP 3 832 389 A1**
(43) Veröffentlichungstag der Anmeldung: **09.06.2021**
(21) Anmeldenummer: 19214306.3
(22) Anmeldetag: 06.12.2019
(51) Int. Cl.: G03F 7/11, G03F 7/16, G03F 7/20, G03F 7/32, G03F 7/36, G03F 7/021, G03F 7/016

(54) **HOCHAUFLÖSENDE FLEXODRUCKPLATTE UND MITTEL ZU DEREN HERSTELLUNG MIT VERBESSERTER SPERRSCHICHT UND HAFTUNGSMODULIERENDE SCHICHT**

(71) Anmelder: Folex AG, 6423 Seewen (CH)
(72) Erfinder: Varescon, Francois, 6440 Brunnen (CH); Osenegg, Carlfried, 6403 Küssnach am Rigi (CH); Nigg, Robert, 6442 Gersau (CH); Sutter, Daniel, 6318 Walchwil (CH)
(74) Vertreter: Rüedi, Regula Béatrice

(57) **Zusammenfassung**

Beschrieben wird ein zur Herstellung von hochauflösenden Flexodruckplatten durch digitale Informationsübertragung geeignetes mit aktinischer Laserstrahlung bebilderbares Aufzeichnungselement, welches die folgenden Schichten enthält oder daraus besteht:
**(A)** eine Trägerfolie,
**(B)** eine fotopolymerisierbare Schicht/reliefbildende Polymerschicht, die durch aktinische Strahlung vernetzbar ist,
**(C)** einen für aktinische Strahlung transparenten Zwischenschichtverbund, der aus mindestens 2 übereinander angeordneten polymerhaltigen Schichten besteht, einer ersten Verbundschicht **(C1),** die als Sperr- oder Barriereschicht wirkt, und einer zweiten verbundschicht **(C2),** die gegenüber der reliefbildenden Polymerschicht haftungsmodulierend wirkt,
**(D)** eine aufzeichnungsfähige Vorlageschicht umfassend eine monomere Diazonium-Verbindung und
**(El)** gegebenenfalls eine auf der aufzeichnungsfähigen Vorlageschicht **(D)** angeordnete abziehbare Schutz- oder Deckfolie.

## Beschreibung

### Gebiet der Erfindung

Die Erfindung betrifft Aufzeichnungselemente zur Herstellung hochauflösender Flexodruckplatten, die zur digitalen Informationsübertragung geeignet sind, sowie Mittel zu deren Herstellung und Verfahren zur Herstellung hochaufgelöster Flexodruckplatten mit verbesserten Eigenschaften einer zwischen Reliefschicht und aufzeichnungsfähiger Vorlageschicht liegenden Zwischenschicht.

### Hintergrund

Aufzeichnungselemente für digitale Informationsaufnahme sind prinzipiell bekannt. Sie bestehen - für die Herstellung herkömmlicher Flexodruckplatten - aus mindestens einem Träger, einer fotopolymerisierbaren Schicht sowie einer Schicht, die fähig ist digitale Information aufzuzeichnen (aufzeichnungsfähige Vorlageschicht).

Bei den aufzeichnungsfähigen Vorlageschichten kann es sich beispielweise um eine Schicht auf Basis eines Fotopolymers (siehe EP 0797120 A2 und EP 0913730 B1), um eine mittels Ink-Jet bedruckbare Schicht (siehe US7875321 B2), um eine thermografische Schicht (siehe DE60125755 T2, US2014370440 A1 und US2003/211423 A1), um eine Silberhalogenidemulsions-Schicht oder eine laserablatierbare Schicht (siehe US2008258344 A1, WO2015040094 A2, WO 2016188981 A1) handeln, wobei die Art der aufzeichnungsfähigen Schicht für die Qualität der Wiedergabe der niedrigen und hohen Tonwerte der Druckerzeugnisse verantwortlich ist.

Die für den Druck entscheidende Schicht der digitalen Flexodruckplatten ist die auf einem Träger (üblicherweise einer Folie aus Polyethylenterephthalat (PET)) angeordnete fotopolymerisierbare Schicht. In der Folge wird diese fotopolymerisierbare Schicht auch als reliefbildende Polymerschicht bezeichnet, da diese nach dem Auswaschprozess das endgültige Druckplattenprofil ergibt. Bei der Erstellung des Druckplattenprofils kommt der aufzeichnungsfähigen Schicht eine wichtige Rolle zu, da diese für die Auflösung des Druckplattenprofils verantwortlich ist. Diese Auflösung umfasst unter anderem die Wiedergabe der feinen Druckelemente und der niedrigen und hohen Tonwerte, insbesondere im Bereich von 0 bis 5% bzw. 95 bis 100 % der Rasterpunkte.

Die oben erwähnten Verfahren mit einer aufzeichnungsfähigen Schicht auf Basis einer Ink-Jet bedruckbaren Schicht, einer thermografischen Schicht oder einer laserablatierbaren Schicht (auch als LAMS (Laserablatierbare Maskenschichten) bezeichnet) zeigen nicht die gewünschten Druckergebnisse in Bezug auf die Wiedergabe der feinen Druckelemente und der niedrigen und hohen Tonwerte im Bereich von 0-5% und 95-100% der Rasterpunkte bei hoher Auflösung (80 Linien/cm, 4400dpi).

Die angewandten Belichtungstechnologien für die Herstellung der Druckplatten benötigen zudem zwei verschiedene Belichtungseinheiten, die ein wichtiger Kostenfaktor in der Plattenherstellung sind. Zusätzlich tritt während des Belichtungsprozesses Sauerstoffangriff auf, der bei doppelter Belichtung verstärkt wird.

Aus EP 0 797 120 A2 ist die Verwendung einer aufzeichnungsfähigen Schicht auf Basis eines Fotopolymers bekannt. Diese Schicht besteht aus einer arylazophosphonathaltigen Verbindung der Formel 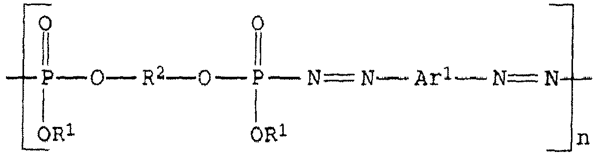 worin R¹, R², Ar¹ und n die in EP 0 797 120 A2, Seiten 5 und 6, angegebene Bedeutung haben.

Durch Belichtung mittels aktinischer Laserstrahlung erfährt die Schicht mit einer optischen Dichte im aktinischen Bereich von >2.5 an den belichteten Stellen eine Änderung der optischen Dichte um >1 unter hohen Energie-Werten von >5 bis zu 50 J/cm².

Nach Belichtung bzw. Vernetzung können die aufzeichnungsfähige Vorlageschicht und die nichtvernetzten Teile der reliefbildende Polymerschicht mittels eines oder mehrerer Entwickler entfernt werden.

Ein solches Aufzeichnungsmaterial soll gleiche Eigenschaften aufweisen, wie ein Aufzeichnungsmaterial gemäss Vergleichsbeispiel.

Ein Material gemäss EP 0 797 120 A2 weist die folgenden Probleme auf:
Die arylazophosphonathaltigen Verbindungen können monomere oder oligomere (n=1 bis 10) Verbindungen sein. Insbesondere solche oligomere Verbindungen als Bestandteil einer ablatierbaren Schicht können nur unter Absorption hoher UV-Strahlung zerstört (<320 nm) werden. Dies benötigt den Einsatz von kostenintensiven Excimer-Lasern z.B. eines XeCl-Lasers (Wellenlänge: 308 nm).

Zusätzlich sind Schichten, die arylazophosphonathaltige Polymere enthalten, nicht stabil und altern sehr schnell.

In der Patentanmeldung EP 3 401 732 A1 wird eine aufzeichnungsfähige Vorlageschicht umfassend eine gegenüber aktinischer Laserstrahlung empfindliche monomere Diazonium-Verbindung als Bestandteil eines Aufzeichnungselements für die Herstellung einer digital bebilderbaren Flexodruckplatte beschrieben. Die hohe Auflösung der Rasterpunkte unter den niedrigen und über den hohen Tonwerten im Bereich von 0-5% und/oder 95-100% wird u.a. mittels einer dünnen Folie oder einer Zwischenschicht unter 20 µm erreicht. Durch die Zwischenschicht werden die Bebilderungs- und Vernetzungsprozesse zeitlich verkürzt und der Sauerstoffangriff während des Belichtungsverfahrens wird stark vermindert.

Leider zeigt das Produkt bzw. das angewandte Verfahren Grenzen bei der Herstellung des Halbfabrikats aus Folie (C) und aufzeichnungsfähiger Vorlageschicht (D) bzw. der Anwendung des Halbfabrikats in der Fertigung digital bebilderbarer Druckplatten. Bei sehr dünnen Zwischenfolien (Dicke < 20 µm) kommt es zu Faltenbildungen, schlechter Dimensionsstabilität und deswegen zu ungleichmässiger Übertragung und Laminierung auf die reliefbildende Polymerschicht. Mit anderen Worten, eine Zwischenfolie mit einer Dicke von unter 20 µm und mit darauf aufgebrachter aufzeichnungsfähiger Vorlageschicht lässt sich sehr schlecht verarbeiten, bzw. führt zu einem suboptimalen Produkt.

Die in EP 3 401 732 A1 als Alternative zu der dünnen Folie beschriebene Verwendung einer Zwischenschicht (C), aus einem Polymer, wie Poyvinylbutyral (PVB) oder Polyvinylalkohol, als Bindemittel sind nur mässig geeignet. Zwar entfällt die Faltenbildung, dafür wurde Diffusion der Diazoverbindung aus der aufzeichnungsfähigen Vorlageschicht in die Reliefschicht und umgekehrt der Monomeren aus der Reliefschicht in die Vorlageschicht beobachtet, was die Alterungsstabilität der Druckplatte eindeutig beeinträchtigt.

Aufgabe der vorliegenden Erfindung war es deshalb, ein zur Herstellung von hochauflösenden Flexodruckplatten geeignetes Aufzeichnungsmaterial mit verbesserter haftungsmodulierender Schicht als Zwischenschicht bereitzustellen, das für digitale Informationsübertragung geeignet ist und bei dem mindestens einer, vorzugsweise mehrere, insbesondere alle der nachfolgenden Teilaufgaben a) bis g) erfüllt ist/sind:
a) Die Auflösung der Rasterpunkte unter den niedrigen und über den hohen Tonwerten im Bereich von 0-5% und/oder 95-100% wird (im Vergleich zur Patentanmeldung EP 3 401 732 A1) verbessert. Diese übertrifft die Auflösung, welche mit den Ende 2018 bekannten, beispielsweise von Dupont unter der Bezeichnung Cyrel® Now oder FDT vertriebenen Platten erhältlich ist, die konventionelle Silberhalogenidverfahren verwenden, oder laserablatierbare (LAMS) Schichten, wie nyloflex® ACE 170 Digital von Flint, CYREL® DSP/DPN von Dupont oder Digital LUX-ITP von Mac Dermid.
b) Die Bebilderungs- und Vernetzungsprozesse werden zeitlich verkürzt.
c) Der Sauerstoffangriff während des Belichtungsverfahrens wird stark vermindert, wobei kein zusätzliches Hilfsmittel, wie Stickstoffatmosphäre, benötigt wird.
d) Die aufzeichnungsfähige Vorlageschicht und die Zwischenschicht mit guten Sperrschichteigenschaften sollen nach der UV-Belichtung vor dem Auswaschprozess leicht entfernbar sein, ohne die Oberflächenstruktur der UV-belichteten Druckplatte zu beschädigen.
e) Die Fertigung des Halbfabrikats (Folie und aufzeichnungsfähige Vorlageschicht), das zur Anwendung in der Fertigung der digital bebilderbaren Druckplatte kommt, wird durch Gleichmässigkeit der Laminierung und Eliminierung der Falten verbessert.
f) Gute Alterungsbeständigkeit des Aufzeichnungselements.
g) Es ist kein Laser notwendig, der sehr kurzwellige Laserstrahlung (<320 nm) erzeugt.

### Darstellung der Erfindung

Mindestens eine, insbesondere alle der oben angegebenen Teilaufgaben wurden gelöst durch Bereitstellen eines Aufzeichnungselements, das mit Ausnahme der Zwischenschicht bzw. Zwischenfolie identisch ist mit den in EP 3 401 732 A1 und dessen Zwischenschicht ein Zwischenschichtverbund aus mindestens zwei übereinander angeordneten Verbundschichten ist, wobei eine zweite Verbundschicht eine auf der Reliefschicht angeordnete haftungsmodulierende Schicht ist und eine erste Verbundschicht eine zwischen der zweiten Verbundschicht und der aufzeichnungsfähigen Vorlageschicht angeordnete Sperrschicht gegenüber den in der aufzeichnungsfähigen Vorlageschicht enthaltenen Diazonium-Verbindungen ist.

Ein solcher, für aktinische Strahlung transparenter Zwischenschichtverbund erfüllt als Hauptfunktion:
a)Einerseits das saubere Separieren der reliefbildenden Polymerschicht (B) von der aufzeichnungsfähigen Vorlageschicht (D), d.h. das Verhindern von Diffusion zwischen den Schichten. Die Diffusion von Monomeren und Additiven, die in der reliefbildenden Polymerschicht (B) enthalten sind, beeinträchtigen die Stabilität der aufzeichnungsfähigen Schicht (D) und deren Auflösung.
b) Andererseits das leichte Entfernen der bebilderten Vorlageschicht (D) mit dem Zwischenschichtverbund (C) von der reliefbildenden Polymerschicht (B) nach Belichten des Aufzeichnungselements mit aktinischer Strahlung durch die bebilderte Vorlageschicht hindurch. Es wurde nämlich gefunden, dass eine reine Zwischenschicht z.B. aus Polyester oder Copolyester zwar Diffusion verhindert, sich aber nicht von der reliefbildenden Polymerschicht (B) abziehen lässt.

Üblicherweise hat der für aktinische Strahlung transparente Zwischenschichtverbund (C) eine Dicke von bis zu 100 µm, wie 0.1 µm bis 100 µm, vorzugsweise von 0.2 µm bis 50 µm, insbesondere von 0.4 µm bis 30 µm, speziell bevorzugt von 0.6 µm bis 20 µm, wie 8 µm.

Obschon dünne Zwischenschichtverbunde bevorzugt sind, zeigen auch dickere Verbunde oft Vorteile gegenüber Folien, z.B. bessere Auflösung weil die Schichten mittels Flüssigauftrag übereinander aufgebaut sind, was zu innigem Kontakt zwischen den Schichten führt.

Der für aktinische Strahlung transparente Zwischenschichtverbund (C) besteht aus 2 getrennten polymerhaltigen Schichten: Die erste Verbundschicht (C1) als Sperrschicht spielt die Rolle einer Barriereschicht, die direkt in Kontakt mit der aufzeichnungsfähigen Vorlageschicht(D) ist. Die erste Verbundschicht (C1) verhindert nicht nur die Migration und/oder die Diffusion von vorzugsweise jeder in der Vorlageschicht (D) enthaltenen Komponente in die zweite Schicht (C2) und die reliefbildende Polymerschicht sondern sie verhindert auch die Nachdiffusion von Sauerstoff in die reliefbildende Polymerschicht(B). Die auf der reliefbildenden Polymerschicht angeordnete zweite Schicht (C2) lässt sich nach den abgeschlossenen Belichtungsprozessen leicht mechanisch entfernen.

Ein solcher Zwischenschichtverbund ist insbesondere geeignet in Verbindung mit einer aufzeichnungsfähigen Vorlageschicht auf Basis von gegenüber aktinischer Laserstrahlung empfindlichen Diazoniumverbindungen. Eine solche aufzeichnungsfähige Vorlageschicht (D) zusammen mit einem Zwischenschichtverbund (C) kann Bestandteil eines Halbfabrikats für die Herstellung eines Aufzeichnungsmaterials sein, oder die aufzeichnungsfähige Vorlageschicht (D) und der Zwischenschichtverbund (C) können Bestandteil eines Aufzeichnungselements sein, welches alle für die Herstellung einer Flexodruckplatte erforderlichen Schichten umfasst. Bei diesen Schichten handelt es sich insbesondere um einen Träger (A), eine durch aktinische Strahlung vernetzbare herkömmliche Fotopolymer-Schicht (B),die auch als reliefbildende Polymerschicht bezeichnet wird, einen polymerhaltigen Zwischenschichtverbund (C), eine mittels digitaler Verfahren aufzeichnungsfähige Vorlageschicht (D) auf Basis von Diazoniumverbindungen und eine auf der Schicht (D) aufgebrachte Schutzfolie (E1).

Insbesondere betrifft die vorliegende Erfindung in einem Aspekt ein zur Herstellung von hochauflösenden Flexodruckplatten durch digitale Informationsübertragung geeignetes, mit aktinischer Laserstrahlung bebilderbares Aufzeichnungselement, welches in der genannten Reihenfolge übereinander angeordnet die folgenden Schichten enthält oder daraus besteht:
**(A)** eine Trägerfolie, insbesondere eine Kunststofffolie, die optional auf der mit einer fotopolymeriserbaren Schicht/ reliefbildenden Polymerschicht versehenen Seite mit einer Haftschicht versehen sein kann,
**(B)** eine in organischen und/oder wässerigen Lösemitteln lösliche und/oder durch Erwärmen flüssige oder/und flüchtige fotopolymerisierbare Schicht/ reliefbildende Polymerschicht, die durch aktinische Strahlung vernetzbar ist,
**(C)** ein für aktinische Strahlung transparenter Zwischenschichtverbund, der aus mindestens 2 übereinander liegenden polymerhaltigen Verbundschichten besteht, wobei eine zweite Verbundschicht (C2) eine auf der Reliefschicht angeordnete haftungsmodulierende Schicht ist und eine erste Verbundschicht (C1) eine zwischen der zweiten Verbundschicht (C2) und der aufzeichnungsfähigen Vorlageschicht (D) angeordnete Sperrschicht gegenüber den in der aufzeichnungsfähigen Vorlageschicht (D) enthaltenen Diazonium-Verbindungen ist.
**(D)** eine aufzeichnungsfähige Vorlageschicht umfassend eine monomere Diazonium-Verbindung, die gegen aktinische Laserstrahlung lichtempfindlich ist und durch Entwickeln eine Änderung in der aktinischen Dichte erfährt oder eine bebilderte Vorlageschicht, in der die monomere Diazonium-Verbindung in mindestens einem Bereich durch aktinische Laserstrahlung zerstört ist und in mindestens einem nicht belichteten Bereich infolge Entwickelns eine erhöhte aktinische Dichte hat.

In einer Ausführungsform weist das erfindungsgemässe Aufzeichnungselement zusätzlich
**(E1)** eine auf der aufzeichnungsfähigen Vorlageschicht **(D)** angeordnete abziehbare Schutz- oder Deckfolie auf. Eine solche Schutz- oder Deckfolie soll zum Schutz der in der aufzeichnungsfähigen Vorlageschicht (D) enthaltenen monomere Diazonium-Verbindung lichtdicht (aktinisch dicht) sein, und kann aus Kunststoff oder Papier oder Verbundmaterialien bestehen.
   In einem zweiten Aspekt betrifft die Erfindung ein Halbfabrikat für die Herstellung eines Aufzeichnungselements, wie oben beschrieben. Dieses umfasst
**(E1)** eine abziehbare, vorzugsweise lichtdichte (aktinisch dichte) Schutz- oder Deckfolie, die auch als Träger dient,
**(D)** eine aufzeichnungsfähige Vorlageschicht umfassend eine monomere Diazonium-Verbindung, die gegen aktinische Laserstrahlung lichtempfindlich ist und durch Entwickeln eine Änderung in der aktinischen Dichte erfährt,
**(C)** einen für aktinische Strahlung transparenten Zwischenschichtverbund, der aus mindestens 2 aufeinander liegenden polymerhaltigen Verbundschichten besteht, wobei eine zweite Verbundschicht (C2) eine auf der Reliefschicht angeordnete haftungsmodulierende Schicht ist und eine erste Verbundschicht (C1) eine zwischen der zweiten Verbundschicht (C2) und der aufzeichnungsfähigen Vorlageschicht (D) angeordnete Sperrschicht gegenüber den in der aufzeichnungsfähigen Vorlageschicht (D) enthaltenen Diazonium-Verbindungen ist,
**(E2)** gegebenenfalls und vorzugsweise eine Schutzfolie.

Die Folien **(E1)** und **(E2)** sind Schutz- oder Deckfolien, die gleichzeitig Trägerfunktion ausüben können. Die Folien (E1) und (E2) können aus Kunststoff oder Papier oder Verbundmaterialien sein. Sie sollen für aktinische Strahlung lichtdicht sein.

Ein solches Halbfabrikat kann wie folgt hergestellt werden:
(i) **Bereitstellen** einer eine Schutz- oder Trägerfolie **(E1)**
(ii) einseitiges **Auftragen und Trocknen** einer Formulierung für die aufzeichnungsfähige Vorlageschicht **(D)**
(ii) **Auftragen und Trocknen** einer Formulierung für eine Barriereschicht **(C1)** auf die Schicht **(D)**,
(iv) **Auftragen und Trocknen** einer Formulierung für eine haftungsmodulierende Schicht **(C2)** auf die Barriereschicht **(C1)**,
(v) gegebenenfalls **Aufbringen** einer Schutzschicht **(E2)** auf die haftungsmodulierende Schicht **(C2)** .

Die Trocknung erfolgt bei einer Temperatur, die abhängig ist von den verwendeten Lösungsmitteln, der thermischen Stabilität der schichtbildenden Komponenten und der gewünschten Trocknungszeit. Geeignete Trocknungstemperaturen bewegen sich im Bereich von 50 bis 150 °C. Die Trocknungszeiten sind vorzugsweise alle gleich lang und bewegen sich im Bereich von unter 5 Minuten, wie 1 bis 3 Minuten, insbesondere ca. 2 Minuten.

Ein solches Halbfabrikat kann zusammen mit einem Flexodruckelement umfassend eine Trägerfolie **(A),** eine reliefbildende Polymerschicht **(B),** gegebenenfalls eine Haftschicht zwischen der reliefbildenden Polymerschicht **(B)** und der Trägerfolie **(A)** und gegebenenfalls eine abziehbare Schutz- oder Deckfolie **(E3)** auf der reliefbildenden Polymerschicht **(B)** wie folgt zu einem Aufzeichnungselement weiterverarbeitet werden:
(i) **entfernen** gegebenenfalls vorhandener Schutz- oder Deckfolien **(E2), (E3)** von dem für aktinische Strahlung transparenten Zwischenschichtverbund **(C)** und von der reliefbildende Polymerschicht **(B),**
(ii) **transferieren und laminieren** des Halbzeugs aus der Folie **(E1)**, der aufzeichnungsfähigen Vorlageschicht **(D)** und dem für aktinische Strahlung transparenten Zwischenschichtverbund **(C)** mit dem Zwischenschichtverbund **(C)** auf die reliefbildende Polymerschicht **(B)** des Flexodruckelements.

Ebenfalls Gegenstand der vorliegenden Erfindung ist ein Verfahren zur Herstellung hochauflösender Flexodruckplatten unter Verwendung eines erfindungsgemässen Aufzeichnungselements und dessen Bebilderung mittels digitaler Informationsübertragung unter Verwendung aktinischer Laserstrahlung. Dieses Verfahren umfasst die folgenden Verfahrensschritte:
**(1)** gegebenenfalls **Abziehen** der Deckfolie **(E1)**,
**(2) Belichten** der aufzeichnungsfähigen Vorlageschicht **(D)** mittels aktinischer Laserstrahlung unter Bildung einer belichteten Vorlageschicht,
**(3) Entwickeln** der belichteten Vorlageschicht **(D)** unter Bildung einer bebilderten Vorlageschicht **(D)**,
**(4) Belichten** des mit der bebilderten Vorlageschicht **(D)** versehenen Aufzeichnungselements mit aktinischer Strahlung durch die bebilderte Vorlageschicht **(D)** hindurch.
**(5) mechanisch Entfernen** der Vorlageschicht **(D)** und des vorhandenen Zwischenschichtverbunds **(C)** sowie **chemisch und/oder thermisch Entfernen** der nicht polymerisierten Anteile der reliefbildenden Polymerschicht**(B)** unter Bildung der Flexodruckplatte,
**(6) Trocknen** der erhaltenen Flexodruckplatte und
**(7)** gegebenenfalls und vorzugsweise **Nachbehandeln** der Flexodruckplatte mit UV-Licht.

Das Entfernen des Zwischenschichtverbunds (C) zusammen mit der bebilderten Vorlageschicht(D) erfolgt vorzugsweise mechanisch. Das Entfernen der nicht polymerisierten Anteile der reliefbildenden Polymerschicht (B) erfolgt vorzugsweise chemisch. Sowohl das Entfernen des Zwischenschichtverbunds, wie auch das Entfernen der nicht polymerisierten Anteile der reliefbildenden Polymerschicht(B) können bei erhöhter Temperatur erfolgen.

### Kurze Beschreibung der Zeichnung

Weitere Ausgestaltungen, Vorteile und Anwendungen der Erfindung ergeben sich aus den abhängigen Ansprüchen und aus den Figuren, wobei
**Figur 1****,** die Herstellung eines Aufzeichnungselements ausgehend von einem Halbfabrikat mit Zwischenschichtverbund (C) aus zwei Verbundschichten (C1) und (C2) beschreibt und
**Figur 2** die Herstellung einer Flexodruckplatte ausgehend von einem Aufzeichnungselement gemäss Figur 1.

### Wege zur Ausführung der Erfindung

Das erfindungsgemässe, zur Herstellung von hochauflösenden Flexodruckplatten durch digitale Informationsübertragung geeignete mit aktinischer Laserstrahlung bebilderbare oder bebilderte Aufzeichnungselement enthält die oder besteht aus den folgenden Schichten, die in der genannten Reihenfolge übereinander angeordnet sind:
**(A)** eine Trägerfolie, die optional auf der mit einer fotopolymeriserbaren Schicht/reliefbildenden Polymerschicht versehenen Seite mit einer Haftschicht versehen sein kann,
**(B)** eine in organischen und/oder wässerigen Lösemitteln lösliche und/oder durch Erwärmen flüssige oder/und flüchtige fotopolymerisierbare Schicht/ reliefbildende Polymerschicht, die durch aktinische Strahlung vernetzbar ist,
**(C)** ein für aktinische Strahlung transparenter Zwischenschichtverbund als Trennelement, wobei der Zwischenschichtverbund aus mindestens 2 und bevorzugt zwei aufeinander liegenden polymerhaltigen Schichten besteht, wobei eine zweite Verbundschicht (C2) eine auf der Reliefschicht angeordnete haftungsmodulierende Schicht ist und eine erste Verbundschicht (C1) eine zwischen der zweiten Verbundschicht (C2) und der aufzeichnungsfähigen Vorlageschicht (D) angeordnete Sperrschicht gegenüber den in der aufzeichnungsfähigen Vorlageschicht (D) enthaltenen Diazonium-Verbindungen ist,
**(D)** eine aufzeichnungsfähige Vorlageschicht umfassend eine monomere Diazonium-Verbindung, die gegen aktinische Laserstrahlung lichtempfindlich ist und durch Entwickeln eine Änderung in der aktinischen Dichte erfährt oder eine bebilderte Vorlageschicht, in der die monomere Diazonium-Verbindung in mindestens einem Bereich durch aktinische Laserstrahlung zerstört ist und in mindestens einem nicht belichteten Bereich infolge Entwickelns eine erhöhte aktinische Dichte hat. Das Aufzeichnungselement umfasst zum Schutz gegen Verschmutzung auf der aufzeichnungsfähigen Vorlageschicht (D) gegebenenfalls und bevorzugt zusätzlich
**(E1)** eine abziehbare Schutz- oder Deckfolie.

Zweck der aufzeichnungsfähigen Schicht (D) ist deren Bebilderung mittels Laserstrahlung und anschliessendem Entwicklungsprozess unter Bildung einer Vorlage (Maske) für die aktinische Bestrahlung der Schicht (B) mit dem angestrebt hohen Auflösungsvermögen. Die Auflösung der Vorlageschicht (D) liegt im Molekularbereich.

**(E1)** ist eine abziehbare lichtdichte (aktinisch dichte) Schutz- oder Deckfolie. Eine solche umfasst das Aufzeichnungselement zum Schutz der aufzeichnungsfähigen Vorlageschicht (D) gegen Verschmutzung und Licht vorzugsweise zusätzlich.

Die aufzeichnungsfähige Vorlageschicht **(D)** weist üblicherweise eine Schichtdicke von 1 µm bis 50 µm auf, vorzugsweise von 3 µm bis 30 µm, und kann mit aktinischer Laserstrahlung einer Leistung von vorzugsweise 10 bis 1500 mJ/cm² im Spektralbereich von 330 nm bis 430 nm, insbesondere von 50 bis 1000 mJ/cm² im angegebenen Spektralbereich, belichtet werden.

Bevorzugt ist eine aufzeichnungsfähige Vorlageschicht (D), die mittels alkalischer Lösung oder alkalischer Dämpfe, wie mittels Ammoniak, insbesondere Ammoniak-Dampf, entwickelt werden kann. Infolge des Entwickelns werden die nicht belichteten Bereiche für die zur Vernetzung der reliefbildenden Polymerschicht geeignete aktinische Strahlung weniger durchlässig. Gut geeignet sind Materialien, deren nicht belichtete Bereiche nach Entwickeln eine Differenz in der aktinischen Dichte > 3.0 aufweisen.

Bevorzugte aufzeichnungsfähige Vorlageschichten bestehen zu mindestens 70 Gew.-%, vorzugsweise zu mindestens 85 Gew.-% aus einem Gemisch aus
(i) mindesten einem auf Celluloseester basierten Bindemittel, insbesondere Celluloseacetatpropionat (CAP) und/oder Celluloseacetatbutyrat (CAB), und
(ii) mindestens einer Diazoniumverbindung gemäss Formel **(I)**

   **R-N⁺≡N X⁻** **(I)**

   **worin R** eine substituierte oder unsubstituierte organische Gruppe wie eine Alkyl-, Acyl-, oder eine aromatische Gruppe bedeutet,
   **X⁻** ein Anion ist, insbesondere ausgewählt aus der Gruppe umfassend BF₄⁻, AsF₆⁻, ClO₄⁻, SbF₆⁻, CF₃SO₃⁻, SO₄⁻, PF₆⁻ PO₄³⁻, NO₃⁻, Br⁻, Cl⁻, I⁻, F⁻, Arylsulfonat, wie p-Chlorbenzolsulfonat, Alkylsulfonat, Allylsulfonat, oder ein Metallkomplexanion, z.B. ZnCl₃⁻, SnCl₆²⁻
(iii) in Kombination mit mindestens einer reaktiven Kuppler-Verbindung.

Das Verhältnis von Bindemittel zu Diazoverbindung beträgt üblicherweise von 50 : 1 bis 1 : 2, vorzugsweise 20 : 1 bis 1 : 1 und das Verhältnis von Diazoverbindung zu Kupplerverbindung von 4 : 1 bis 1 : 4, vorzugsweise 2 : 1 bis 1 : 2.

Vorzugsweise ist **R** eine aromatische Gruppe, deren Ring unabhängig von ihrer Stellung zur Diazoniumgruppe mit den Substituenten A, B und C gemäss Formel (Ia) substituiert ist. 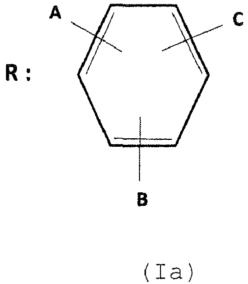 worin
A, B und C gleich oder verschieden sein können und ausgewählt sind aus der Gruppe umfassend Halogenatom, Wasserstoffatom, Aminogruppen, Thiogruppen, Nitrogruppe, Sulfogruppe, Acylreste, Carbalkoxyreste, Sulfonylreste, Cyanorest oder Carboxylrest.

Inbesondere haben die Gruppen A, B und C in ihrer bevorzugten Ortho-, Para- oder Metastellung zur Diazoniumgruppe die folgende Bedeutung:
**A** in Orthostellung zur Diazoniumgruppe ist ausgewählt aus der Gruppe umfassend Halogenatom, Wasserstoffatom, Nitrogruppe, Sulfogruppe oder organische Gruppe, wobei die organische Gruppe insbesondere ein Acyl-, Carbalkoxy-, Sulfonyl-, Cyano- oder Carboxyrest ist,
**B** in Parastellung zur Diazoniumgruppe ist ausgewählt aus
   (i) gegebenenfalls mono- oder disubstituierten Aminogruppen, wobei die Substituenten jeweils unabhängig voneinander ausgewählt sind aus der Gruppe umfassend Alkylreste, Arylreste, Alkoxyreste und Phenoxyreste, oder die beiden Substituenten bilden zusammen mit dem Stickstoff an den sie gebunden sind einen Heterozyklus, oder
   (ii) substituierten Thiogruppen, wobei der Substituent ausgewählt ist aus der Gruppe umfassend Alkylreste und Arylreste.
**C** in Meta- oder Orthostellung zur Diazoniumgruppe ist ausgewählt aus der Gruppe umfassend Acylreste, Carbalkoxyreste, Sulfonylreste, Nitroreste, Cyanoreste, Carboxylreste, Sulforeste, Wasserstoff oder Halogen.

Ein Beispiel für ein geeignetes Diazosalz ist die in den Beispielen verwendete Diazoniumverbindung (Ia) mit A: Cl, B: N(Et)₂ oder N(Me)₂, C: H, X⁻: BF₄⁻ oder PF₆⁻.

Wenn nichts anderes erwähnt ist, können alle Alkylreste und Arylreste substituiert oder unsubstituiert sein und die nachfolgend aufgeführten Gruppen/Reste haben im Rahmen dieser Erfindung die Bedeutung:
"Acylreste" sind insbesondere aliphatische Acylreste mit vorzugsweise bis zu etwa 6 Kohlenstoffatomen im Alkylrest, beispielsweise Formyl-, Acetyl-, Propionyl-, Butyryl-, ß-Phenylacetyl und γ-Chlorpropionylreste oder aromatische Acylreste, wie der Benzoylrest;
"Carbalkoxyreste" sind insbesondere Alkoxycarbonylreste mit vorzugsweise 1 bis 8 Kohlenstoffatomen in der Alkoxygruppe;
"Sulfonylreste" sind insbesondere Alkylsulfonylreste, Arylsulfonylreste und Aminosulfonylreste;
"Sulforeste" sind insbesondere Alkyl- und Arylsulforeste.

Unter "Alkylresten" sind im Rahmen der vorliegenden Erfindung vorzugsweise lineare oder verzweigtkettige, substituierte oder unsubstituierte Alkylreste mit 1 bis etwa 15 Kohlenstoffatomen in der Alkylgruppe zu verstehen, wie Methyl-, Ethyl-. Geeignete Substituenten sind insbesondere Halogenatome, wie Chloratome, Hydroxygruppen, Alkoxygruppen mit 1 bis 5 Kohlenstoffatomen, wie eine Methoxygruppe, Phenoxygruppen und/oder Benzylthiogruppen.

Unter "Arylresten" sind im Rahmen der vorliegenden Erfindung vorzugsweise substituierte und unsubstituierte mono- und polycyclische aromatische Reste mit 6 bis 10 Kohlenstoffatomen, insbesondere der Phenyl- und Naphthylrest zu verstehen. Geeignete Substituenten sind Hydroxyreste, insbesondere Alkylreste mit 1 bis 5 Kohlenstoffatomen, Alkoxyreste mit 1 bis 5 Kohlenstoffatomen und Halogenatome.

Im Rahmen dieser Erfindung als R in Formel (I) geeignete Gruppen sind z.B. beschrieben in DE OS 2 202 251 auf den Seiten 3 bis 8, und in DE 42 41 717 A1 auf S. 3, Z. 30 bis 46 und S. 4, Z. 1 bis S. 5, Z. 50.

Die mindestens eine reaktive Kuppler-Verbindung, ist insbesondere eine Kupplerverbindung der Formel (II) oder (III) 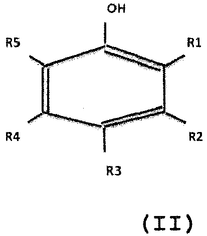
worin **R1**, **R2**, **R3**, **R4 und R5** gleich oder verschieden sein können und ausgewählt sind aus der Gruppe umfassend -OH, -SO₃H, -CONH-R6 (R6=Alkyl-, Aryl-, Cycloalkyl, Alkoxy), Alkoxygruppe, Carboxygruppe, Guanidingruppe, Aminogruppe, Acylamidogruppe, Thioharnstoffgruppe, Thiogruppe, Wasserstoff oder Halogen, oder
**R1 und R2** oder **R2 und R3** zusammen einen Butadienylrest bilden, derart, dass sie zusammen mit dem Phenolring einen substituierten oder unsubstituierten aromatischen Bicyclus (Naphtolstruktur) gemäss Formel (IIa) oder (IIb) bilden

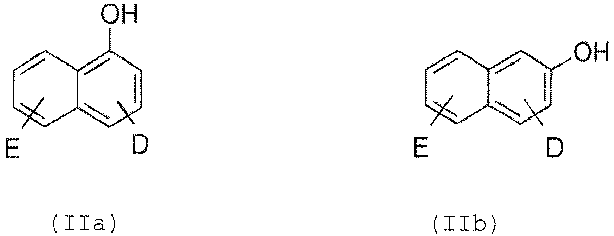

worin **D** und **E** gleich oder verschieden sein können und ausgewählt sind aus der Gruppe umfassend -OH, -SO₃H, -CONH-R6 (R6=Alkyl-,Aryl-, Cycloalkyl, Alkoxy), Alkoxygruppe, Carboxygruppe, Guanidingruppe, Aminogruppe, Acylamidogruppe, Thioharnstoffgruppe, Thiogruppe, Wasserstoff oder Halogen,
   oder
**R1** oder **R2** oder **R3** sind **-OH,** derart, dass ein unsubstituiertes und substituiertes Dihydroxybenzol gemäss Formel **(IIc), (IId) oder (IIe)** vorliegt 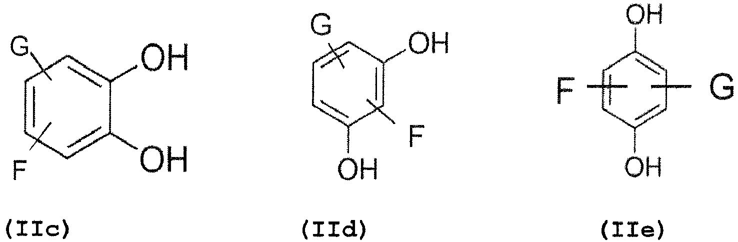
oder
**R1 = R5 = -OH** oder **R1 = R3 = -OH** oder **R2 = R4 = -OH,** derart, dass ein unsubstituiertes oder substituiertes Trihydroxybenzol gemäss Formel **(IIf), (IIg)** oder **(IIh)** vorliegt 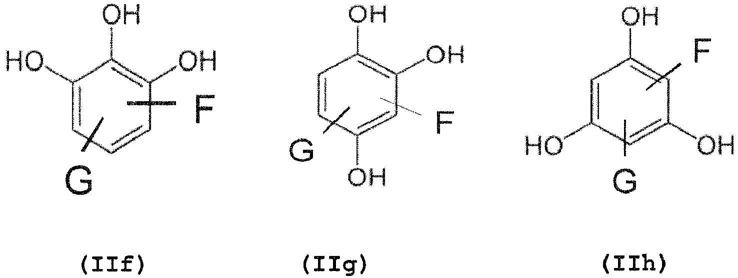 worin F und G gleich oder verschieden sein können und ausgewählt sind aus der Gruppe umfassend -OH, -SO₃H, -CONH-R6 (R6=Alkyl-,Aryl-, Cycloalkyl, Alkoxy), Alkoxygruppe, Carboxygruppe, Guanidingruppe, Aminogruppe, Acylamidogruppe, Thioharnstoffgruppe, Thiogruppe, Wasserstoffatom oder Halogen, z.B. 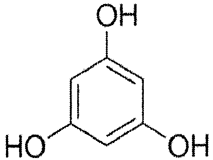 oder worin die Kupplerverbindung ein Biphenol oder Bisphenol der Formel (III) 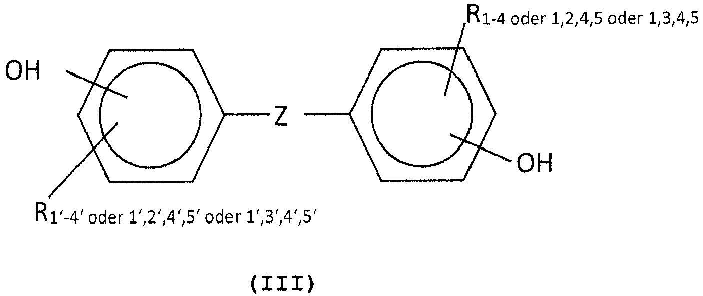
ist, mit **Z** = Bindung, -O- oder -S-, und
worin **R1,R2,R3,R4,R5 und R1',R2',R3',R4',R5'** gleich oder verschieden sein können und ausgewählt sind aus der Gruppe umfassend -OH, -SO₃H, -CONH-R6 (R6=Alkyl-, Aryl-, Cycloalkyl, Alkoxy), Alkoxygruppe, Carboxygruppe, Guanidingruppe, Aminogruppe, Acylamidogruppe, Thioharnstoffgruppe, Thiogruppe, Wasserstoff oder Halogen, z.B. 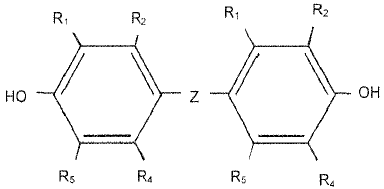 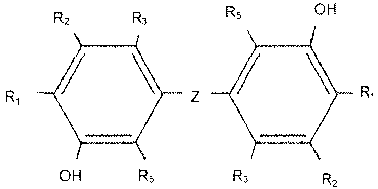 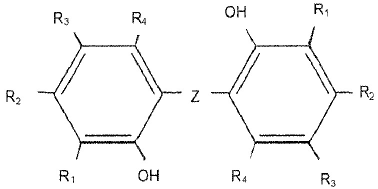
oder ein entsprechendes Bi- oder Bisphenol analog der Formel **(III),** mit je mind. 2 OH-Substituenten pro Phenylring, worin die restlichen R die oben angegebenen Bedeutung haben, z.B.

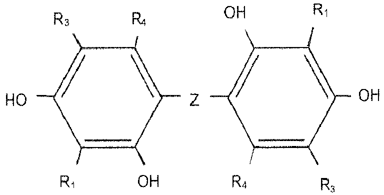

Geeignete Kupplerverbindungen sind z.B. die in den Beispielen verwendeten 3,5-Dihydroxybenzoesäure (Kupplerverbindung (IId) mit F = H und G = (HO)C=O)) und 2,2'-Biphenol (Kupplerverbindung (III) mit R1 bis R4 = H, R1' bis R4' = H und Z = Bindung).

Neben den genannten Bindemitteln, Diazonium-verbindungen und Reaktionskupplern können zur Stabilisierung der Vorlageschicht **(D)** Säuren zugesetzt werden, z.B organische Säuren, wie Zitronensäure, Oxalsäure, Sulfosalicylsäure, Ascorbinsäure, Sulfonsäure, deren pKa zwischen -4.0 und 5.0 liegt und die geeignet sind, einen pH-Wert der fertigen Beschichtungslöung unter 5.0 einzustellen (inbesondere pH unter 3.0). Um das Fliessverhalten zu verbessern können Benetzungsmittel, um die Flexibilität der Schicht zu erhöhen können Weichmacher, um die Rauhigkeit der Schichtoberfläche einzustellen könne Mattierungsmittel, insbesondere auf Basis Silikat, Aluminat oder Polymer, wie Polymethylmethacrylat (PMMA), und um die Haftungseigenschaften der Schicht einzustellen können Vernetzer, insbesondere Melaminharz, zugegeben werden.

Das erfindungsgemässe Aufzeichnungselement weist einen für aktinische Strahlung transparenten Zwischenschichtverbund (C) auf. Ein solcher für aktinische Strahlung transparenter Zwischenschichtverbund erfüllt als Hauptfunktion:
a)Einerseits das saubere Separieren der reliefbildenden Polymerschicht (B) von der aufzeichnungsfähigen Vorlageschicht (D), d.h. das Verhindern von Diffusion zwischen den Schichten. Die Diffusion von Monomeren und Additiven, die in der reliefbildenden Polymerschicht (B) enthalten sind, beeinträchtigen die Stabilität der aufzeichnungs-fähige Schicht (D) und deren Auflösung.
b) Andererseits das leichte Entfernen der bebilderten Vorlageschicht (D) mit dem Zwischenschichtverbund (C)von der reliefbildenden Polymerschicht (B) nach Belichten des Aufzeichnungselements mit aktinischer Strahlung durch die bebilderte Vorlageschicht hindurch. Es wurde nämlich gefunden, dass eine reine Zwischenschicht z.B. aus Polyester oder Copolyester zwar Diffusion verhindert, sich aber nicht von der reliefbildenden Polymerschicht (B) abziehen lässt.

Üblicherweise hat der für aktinische Strahlung transparente Zwischenschichtverbund **(C)** eine Dicke von bis zu 100 µm, wie 0.1 µm bis 100 µm, vorzugsweise von 0.2 µm bis 50 µm, insbesondere von 0.4 µm bis 30 µm, speziell bevorzugt von 0.6 µm bis 20 µm, wie 8 µm.

Der für aktinische Strahlung transparente Zwischenschichtverbund (C) besteht aus 2 aufeinander liegenden polymerhaltigen Schichten: Die erste Verbundschicht (C1) ist eine Sperrschicht und dient als Barriereschicht. Sie steht üblicherweise und bevorzugt direkt in Kontakt mit der aufzeichnungsfähigen Vorlageschicht(D).Sie verhindert nicht nur die Migration und/oder die Diffusion jeder in der Vorlageschicht(D) enthaltenen Komponente sondern auch die Nachdiffusion von Sauerstoff in die zweite Verbundschicht (C2), die auf der reliefbildenden Polymerschicht angeordnet ist, und in die reliefbildende Polymerschicht(B). Die zweite Verbundschicht (C2) lässt sich nach den abgeschlossenen Belichtungsprozessen leicht mechanisch entfernen.

Bevorzugte Verbundschichten (C1) und (C2) des für aktinische Strahlung transparenten Zwischenschichtverbunds (C) sind bevorzugt wie folgt zusammengesetzt:
Die Verbundschicht **(C1)** besteht zu mind. 70 Gew.-%, vorzugsweise zu mind. 85 Gew.-% aus mindesten einem Bindemittel, welches auf mindestens einem in Wasser und/oder organischem Lösungsmittel löslichen Polymer oder Copolymer basiert. Die Sauerstoffdurchlässigkeit der Verbundschicht liegt unter 1000 (cm³ x 100µm)/(m² x d x bar) und ist bevorzugt kleiner als 500 (cm³ x 100µm) / (m² x d x bar). Eine solche Verbundschicht (C1) hat eine Dicke von bis zu 50 µm, wie von 0.05 µm bis 50 µm vorzugsweise von 0.1 µm bis 25 µm, insbesondere von 0.2 µm bis 15 µm, speziell bevorzugt von 0.3 µm bis 10 µm.

Beispiele geeigneter Polymere für die Verbundschicht (C1) umfassen Polymere oder Copolymere, die sich in geeigneten Lösungsmitteln und Lösungsmittelmischungen, wie Naphta, Aromaten, Dioxan, Alkohol, Ketone, Ester oder Mischungen derselben, auflösen lassen. Solche Polymere oder Polymerklassen sind z.B.

Polyester, wiePolyethylenterephthalat (PET), Polybutylenterephthalat (PBT), Polyethylennaphthalat (PEN),
Polymethacrylate, wie Polymethylmethacrylat (PMMA),
Polymilchsäuren (PLA),
Polycarbonate,
Polyamide (PA),
nicht-halogenierte oder halogenierte Polyolefine, wie Polyethylen (PE), Polypropylen (PP), Polymethylpenten (PMP) und Polybutylen (PB, PIB) oder Fluorpolymere, wie Tetrafluorethylen (PTFE), Polyvinylidenchlorid (PVDC), Polyvinylidenfluorid (PVDF), Ethylen-Tetrafluorethylen (ETFE), Polyvinylfluorid (PVF),Perfluorethylenpropylen (PEP, FEP),
Polyarylsufone, wie Polysulfon (PSU) und Polyethersulfon (PES),
Polymere des Vinylalkohols, wie Polyvinylalkohol, Polyvinylacetat (PVA, PVAC), Ethylenvinylacetat-Copolymer (EVAC), Ethylen-vinylalkohol-Copolymer (EVOH) und
Mischung derselben.

Bevorzugt geeignet sind alle gesättigten und ungesättigten Copolyester, wie Polyethylenterephtalat (PET), Polybutylenterephtalat (PBT), Polyethylennaphthalat (PEN) und Polymethylmethacrylat (PMMA), Polymilchsäuren (PLA) und Mischung derselben, insbesondere mit einem Molekulargewicht über 1000 oder Polymere, die unter Handelsnamen wie Dynapol© und Vitel© erhältlich sind.

Um das Fliessverhalten zu verbessern können Benetzungsmittel zugesetzt werden, um die Flexibilität der Schicht zu erhöhen können Weichmacher zugegeben, um die Anbindung der Barriereschicht (C1) an die Vorlageschicht (D) und an die haftungsmodulierende Schicht (C2) zu optimieren, können Zwischenschichthaftungs-Additive zugesetzt werden, um die Kohäsionseigenschaften und zu verbessern, können Kohäsionsadditive wie Nanopartikel aus Siliziumoxid (SiO2, SiOx) oder Aluminiumoxid (AlO₂H, Al(OH)₃, Al₂O₃) oder Vernetzer wie Melaminharz zugeben werden.

Die Verbundschicht **(C2)** besteht zu mind. 70 Gew.-%, vorzugsweise zu mind. 85 Gew.-% aus mindesten einem Bindemittel, welches auf mindestens einem in Wasser und/oder organischem Lösungsmittel löslichen Polymer oder Copolymer basiert, eine Schälkraft zur reliefbildenden Polymerschicht (B) zwischen 0.1 N/m und 100 N/m aufweist und eine Dehnung zwischen 50 - 1500 % aufweist. Eine solche Verbundschicht (C2) hat eine Dicke von bis zu 50 µm, wie von 0.05 µm bis 50 µm vorzugsweise von 0.1 µm bis 25 µm, insbesondere von 0.2 µm bis 15 µm, speziell bevorzugt von 0.3 µm bis 10 µm.

Beispiele geeigneter Polymere für die Verbundschicht (C2) umfassen weichelastische und/oder thermoplastische Polymere oder Copolymere aus den Klassen

Polyvinylalkohole,
teil- oder hochverseifte Polyvinylcarboxylate,
Polyvinylacetate,
Poly(ethylenoxid-vinylalcohol)-Copolymere,
Polyvinylbutyral,
Polyamide,
Polyurethane,
Polyvinylpyrrolidon,
(Silicon-Polyurethan)-Copolymere,
Polyethylenvinylacetat,
Polyolefine,
Polystyrol Homo- oder Copolymere,
Gelatine und
Mischung derselben.

Bevorzugt geeignet sind Polymere und Copolymere aus der Gruppe Polyvinylalkohol, Polyvinypyrrolidon, Polyamid, Polyurethan, (Silicon-Polyurethan)-Copolymere, Gelatine und Mischung derselben. Ebenfalls geeignet sind Polymere, die unter Handelsnamen, wie Technomelt© oder Thermelt©, erhältlich sind.

Um das Fliessverhalten zu verbessern, können Benetzungsmittel zugesetzt werden und um die Flexibilität der Schicht zu erhöhen können Weichmacher zugegeben werden.

Die reliefbildende Polymerschicht **(B)** des Aufzeichnungselements hat üblicherweise eine Schichtdicke von 200 µm bis 8000 µm, insbesondere 300 µm bis 6000 µm. Sie enthält oder besteht aus einem Gemisch aus mindestens einem elastomeren Bindemittel, mindestens zwei ethylenisch ungesättigten copolymerisierbaren organischen Verbindungen (Monomere zur Bildung von beispielsweise Poly(styrol/isopren/styrol)-Blockcopolymeren) und mindestens einem Fotoinitiator oder einem Fotoinitiatorsystem sowie gegebenenfalls weiteren Hilfsstoffen, wie Weichmachern.

Handelsübliche Flexodruckelemente vom Typ (A)+(B)+(E3), die nach Abzug der Deckfolie (E3) als Teil des erfindungsgemässen Aufzeichnungsmaterials eingesetzt werden können, sind erhältlich von Herstellern wie Dupont, Flint, Kodak und Fuji unter deren Bezeichnung:

| | | |
|---|---|---|
| | Dupont : | Cyrel NOW |
| | Flint: | Nyloflex ACE 170 |
| | Kodak: | FLEXCEL NXH- oder Flexcel SR-Platte |
| | Fuji: | Flenex FW |

Die Trägerfolie **(A)** des erfindungsgemässen Aufzeichnungselements hat üblicherweise eine Dicke von 50 µm bis 300 µm.

Geeignete Trägerfolien (A) sind vorzugsweise aus Kunststoff, insbesondere aus für UV-Strahlung transparentem Kunststoff, wie PET, PBT, PEN, oder Polycarbonat. Geeignet sind insbesondere PET-Folien mit einer Dicke von 50 bis 300 µm, vorzugsweise 100 bis 200 µm. Optional können die Trägerfolien (A) mit üblichen haftvermittelnden Schichten behandelt sein.

Ein weiterer Aspekt der Erfindung betrifft ein Halbfabrikat zur Herstellung eines erfindungsgemässen Aufzeichnungselements oder zur Herstellung einer Flexodruckplatte. Ein solches Halbfabrikat zeichnet sich dadurch aus, dass es
**(E1)** eine abziehbare lichtdichte Schutz- oder Deckfolie, die auch als Träger dient,
**(D)** eine aufzeichnungsfähige Vorlageschicht umfassend eine monomere Diazonium-Verbindung, die gegen aktinische Laserstrahlung lichtempfindlich ist und durch Entwickeln eine Änderung in der aktinischen Dichte erfährt,
**(C)** einen für aktinische Strahlung transparenten Zwischenschichtverbund, der aus mindestens 2 übereinander liegenden polymerhaltigen Verbundschichten besteht, wobei eine erste Verbundschicht (C1) eine auf der aufzeichnungsfähigen Vorlageschicht (D) angeordnete Sperrschicht gegenüber den in der aufzeichnungsfähigen Vorlageschicht (D) enthaltenen Diazonium-Verbindungen ist und wobei auf dieser ersten Verbundschicht (C1) eine zweite Verbundschicht (C2) angeordnet ist, die eine haftungsmodulierende Schicht ist und die bei Weiterverarbeitung zum Aufzeichnungselement die Haftung zur reliefbildenden Polymerschicht moduliert,
   enthält oder daraus besteht.

In einer Ausführungsform umfasst das Halbfabrikat auf dem für aktinische Strahlung transparenten Zwischenschichtverbund (C) eine abziehbare Schutz- oder Deckfolie (E2).

Ein weiterer Aspekt der vorliegenden Erfindung ist ein Verfahren zur Herstellung eines erfindungsgemässen Aufzeichnungselements unter Verwendung eines erfindungsgemässen Halbfabrikats und eines Flexodruckelements umfassend eine Trägerfolie (A), eine reliefbildende Polymerschicht (B), gegebenenfalls eine Haftschicht zwischen der reliefbildenden Polymerschicht (B) und der Trägerfolie (A) und gegebenenfalls eine abziehbare Schutz- oder Deckfolie (E3) auf der reliefbildenden Polymerschicht (B).

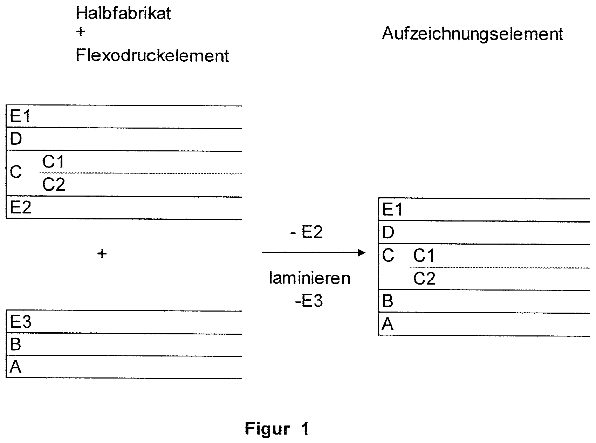

Das Verfahren umfasst die folgenden, auch in Fig. 1 dargestellten Schritte:
(i) **Entfernen** der gegebenenfalls vorhandenen Schutz- oder Deckfolien (E2), (E3) von dem für aktinische Strahlung transparenten Zwischenschichtverbund (C) und von der reliefbildenden Polymerschicht (B) des Flexodruckelements,
(ii) **Transferieren und laminieren** des für aktinische Strahlung transparenten Zwischenschichtverbunds (C) zusammen mit der aufzeichnungsfähigen Vorlageschicht (D) und der Deckfolie (E1) auf die reliefbildende Polymerschicht (B) des Flexodruckelements.

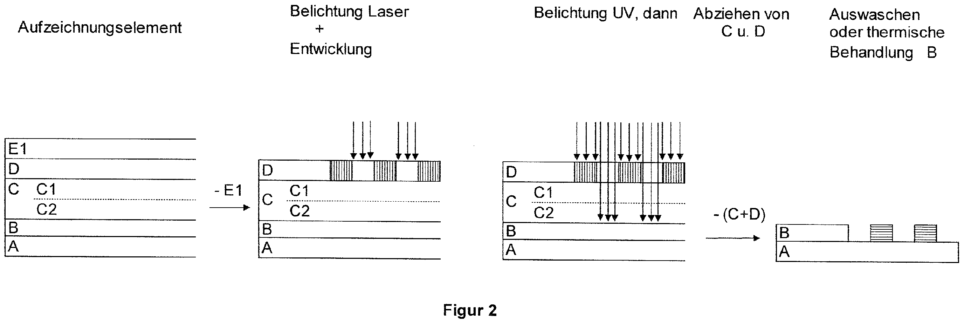

Ein weiterer Aspekt der vorliegenden Erfindung betrifft ein Verfahren zur Herstellung hochauflösender Flexodruckplatten unter Verwendung eines erfindungsgemässen Aufzeichnungselements und Bebilderung mittels digitaler Informationsübertragung unter Verwendung aktinischer Laserstrahlung. Dieses auch in Figur 2 dargestellte Verfahren umfasst die folgenden Verfahrensschritte:
**(1) Abziehen** der Deckfolie (E1),
**(2) Belichten** der aufzeichnungsfähigen Vorlageschicht (D) mittels aktinischer Laserstrahlung unter Bildung einer belichteten Vorlageschicht,
**(3) Entwickeln** der belichteten Vorlageschicht **(D)** unter Bildung einer bebilderten Vorlageschicht (D),
**(4) Belichten** des mit der bebilderten Vorlageschicht (D) versehenen Aufzeichnungselements mit aktinischer Strahlung durch die bebilderte Vorlageschicht (D) hindurch.
**(5) Entfernen** der Vorlageschicht (D) und des vorhandenen Zwischenschichtverbund (C) sowie der nicht polymerisierten Anteile der reliefbildenden Schicht(B) unter Reliefbildung der Flexodruckplatte,
**(6) Trocknen** der erhaltenen Flexodruckplatte und
**(7)** gegebenenfalls und vorzugsweise **Nachbehandeln** der Flexodruckplatte mit UV-Licht.

Bei den Verfahren zur Herstellung von Flexodruckplatten wird die mittels aktinischer Strahlung aufzeichnungsfähige Vorlageschicht (D) üblicherweise mit aktinischer Laserstrahlung von 10 bis 1500 mJ/cm² im Spektralbereich von 330 nm bis 430 nm, insbesondere von 50 bis 1000 mJ/cm² im angegebenen Spektralbereich, belichtet und nach Belichtung mittels alkalischer Lösung oder alkalischem Dampf, wie Ammoniak, insbesondere unter Verwendung von Ammoniakdampf, entwickelt.

Zur Belichtung der reliefbildenden Polymerschicht (B) durch die bebilderte Vorlageschicht (D) und den für aktinische Strahlung transparente Zwischenschichtverbund (C) hindurch geeignet ist aktinische UV-Strahlung von >5 bis 100 J/cm² im Spektralbereich von 200 nm bis 450 nm.

Nach Belichtung der reliefbildenden Polymerschicht mit einer Strahlungsenergie und für eine Zeit, die zur Vernetzung der belichteten Bereiche führt, können
(i) der Zwischenschichtverbund (C) zusammen mit der bebilderten Vorlageschicht (D) mechanisch abgezogen werden, und die nicht polymerisierten Teile der reliefbildenden Polymerschicht (B) können
   - mittels eines Auswaschmittels, welches Wasser und/oder Lösungsmittel enthält oder daraus besteht, oder
   - mittels eines thermischen Verfahren, welches Schmelzen und/oder Verdunsten durch Erwärmen oder Erhitzen erzielt,
      entfernt werden.

### Beispiele

### Herstellung erfindungsgemässer Aufzeichnungselemente

Die Herstellung der erfindungsgemässen Aufzeichnungselemente kann in 3 Stufen erfolgen:
1.- Herstellung eines Flexodruckelements: Die Komponenten der fotopolymerisierbaren reliefbildenden Polymerschicht (B) werden durch einen Extruder auf eine Trägerfolie (A) aufgebracht. Bei der Fertigung eines Flexodruckelements kann eine Schutz/Deckfolie (E3) auf die Aussenseite der reliefbildenden Polymerschicht (B) laminiert werden. Ein solches Flexodruckelement mit oder ohne die Schutz/Deckfolie (E3) wurde als Ausgangsmaterial für die folgenden Beispiele eingesetzt. Geeignete Flexodruckelemente sind kommerziell erhältlich. In den folgenden Beispielen verwendet wurde die Flexoplatte *Nyloflex ACE 170* der Fa. Flint.
2.- Eine PET-Folie (E1) mit oder ohne Haftschicht wurde mit der aufzeichnungsfähigen Vorlageschicht (D) beschichtet. Darüber wurde der Zwischenschichtverbund (C) wie folgt aufgebracht: Die Vorlageschicht (D) auf der PET-Folie (E1) wurde zuerst mit der ersten Verbundschicht (C1), der Barriereschicht/Sperrschicht, beschichtet und anschliessend wurde auf die Barriereschicht die haftungsmodulierende Schicht (C2) aufgetragen. Gegebenenfalls eine Deckfolie (E2) auf der haftungsmodulierenden Schicht diente als Schutzfolie des Halbfabrikats.
3.-Nach Entfernen der Deckfolien (E2) und (E3) wurde der Verbund aus der Träger-, Schutz- oder Deckfolie (E1), der aufzeichnungsfähigen Vorlageschicht(D) und dem Zwischenschichtverbund (C) auf das Flexodruckelement (Schicht (C) auf Schicht (B)) laminiert.

### Herstellung der Beschichtungslösung der aufzeichnungsfähigen Vorlageschicht (D):

In einem Glasbehälter wurden 56 g Methylethyketon und 30 g Methanol vorgelegt. Dann wurden 9 g Celluloseacetatpropionat (CAP)-Bindemittel(erhältlich v. Fa. Sigma-Aldrich) bei Raumtemperatur eingerührt. Nach 40 Minuten wurden 0.9 g Benzolsulfonsäure (erhältlich v. Fa. Sigma-Aldrich)eingerührt. Nach 20 Minuten wurden 2.0 g Diazoniumverbindung (Ia)[A: Cl, B: N(Et)₂, oder N(Me)₂; C: H, X⁻: BF₄⁻ oder PF₆⁻] (erhältlich v. Fa.Chemos GmbH) eingemischt. 20 Minuten später wurden 2 Kupplerverbindungen (II) nacheinander zugegeben: 0.28 g 3,5-Dihydroxybenzoesäure (Kupplerverbindung (IId) mit F = H und G = (HO)C=O)) und 1.70 g 2,2'-Biphenol (Kupplerverbindung (III) mit R1 bis R4 = H, R1' bis R4' = H und Z = Bindung) (erhältlich v. Fa. Aldrich Chemical)) und 0.20 g eines silikonhaltigen Oberflächenadditivs (BYK-300; erhältlich v. Fa. BYK)

### Herstellung der Beschichtungslösungen des Zwischenschichtverbunds (C):

### Barriereschicht (C1)

### Lineare Copolyester / Dynapol®

In einem Glasbehälter wurden 65 g Toluol mit 15 g 1,4-Dioxan gemischt. Danach wurden 20 g Copolyester Dynapol® L 210 (erhältlich von der Firma Evonik) zugesetzt und 3 Stunden gerührt. Die fertige Lösung war einsatzbereit.

Dynapol L 210 wird im Technischen Datenblatt von "Universal Selector" by SpecialChem vom 17.04.2017 beschrieben als gesättigter, linearer, hochmolekularer Copolyester.

### Lineare Copolyester / Vitel®

In einem Glasbehälter wurden 75 g Toluol mit 10 g 1,4-Dioxan gemischt. Danach wurden 15 g Copolyester Vitel® 2475 (erhältlich von der Firma Bostik) zugesetzt und 3 Stunden gerührt. Die fertige Lösung war einsatzbereit.

Vitel® 2475 wird im Technischen Datenblatt vom 14.02.2019 "Bostik Smart adhesives" VITEL ® 2475 Experimental Copolyester coating resin beschrieben als gesättigtes, lineares hochmolekulares Copolyesterharz.

### Haftungsmodulierende Schicht(C2)

### Polyvinylbutyral (Mowital B 16 H) als Haftmodulator

In einem Glasbehälter wurden 70 g IsoPropanol mit 20g Wasser gemischt. Danach wurden 10 g Mowital B 16 H (erhältlich von der Firma Kuraray, zugesetzt und 60 Minuten gerührt. Die fertige Lösung war einsatzbereit.

Mowital B 16 H hat gemäss dem technischen Datenblatt "Mowital" von Kuraray vom August 2016 eine Glasübergangstemperatur von 63°C.

### Polyvinylalkohol als Haftmodulator

In einem Glasbehälter wurden 95 g Wasser mit 0.05 g Capstone FS-30 (ethoxyliertes, nichtionisches Fluortensid) gemischt. Danach wurden 5 g Polyvinylalkohol Poval 40-88 teilverseift (erhältlich von der Firma Kuraray) zugesetzt und 60 Minuten gerührt. Die fertige Lösung war einsatzbereit.

### Polyamid als Haftvermittler

In einem Glasbehälter wurden 42 g Isopropanol mit 42 g Toluol gemischt. Danach wurden 16 g Polyamid Technomelt PA 6900 E (erhältlich von der Firma Henkel) zugesetzt und 60 Minuten gerührt. Die fertige Lösung war einsatzbereit.

Technomelt PA 6900 wird im Technischen Datenblatt vom Januar 2013 beschrieben als aus einem Teil bestehend und auf Polyamid-Technologie beruhend.

### Flexodruckelement

Als Flexodruckelement für die verschiedenen Beispiele wurde die Platte "nyloflex® ACE 170" der Fa. Flint ohne die aufzeichnungsfähige Schicht verwendet. Sie besteht aus einer Trägerfolie (A) mit ca. 125 µm Dicke und aus einer fotopolymerisierbaren reliefbildenden Polymerschicht (B) mit ca. 1650 - 1700 µm Dicke und einer Schutzfolie (E3) mit ca. 125 µm Dicke.

### Vergleichsbeispiel I:

Als aufzeichnungsfähige Schicht wurde ein Diazofilm DPC-HRP der Fa. Folex AG verwendet. Die bebilderte Vorlageschicht wurde gemäss den Verfahrensschritten a) und b) von Vergleichsbeispiel V erhalten und anschliessend auf das Flexodruckelement nyloflex® ACE 170 (ohne russhaltige Schicht (LAMS)) gemäss dem Verfahrensschritt c) von Vergleichsbeispiel V kopiert.

### Vergleichsbeispiel II:

Die aufzeichnungsfähige Schicht (D) war eine russhaltige Schicht (LAMS), die Teil der nyloflex® ACE 170 digital von Flint ist. Die russhaltige Schicht wurde mit einem Lasergerät des Typs Multi DX 220 der Fa. Lüscher bebildert. Danach wurde das bebilderte Aufzeichnungselement gemäss Verfahrensschritt c) von Vergleichsbeispiel V belichtet und weiter verarbeitet.

### Vergleichsbeispiel III:

Die aufzeichnungsfähige Schicht war eine russhaltige Schicht (LAMS), die Teil der CYREL® DSP Platte von Dupont ist. Die russhaltige Schicht wurde mit Multi DX 220 der Fa. Lüscher bebildert. Danach wurde das bebilderte Aufzeichnungselement gemäss Verfahrensschritt c) von Vergleichsbeispiel V belichtet und weiter verarbeitet.

### Vergleichsbeispiel IV:

Die aufzeichnungsfähige Schicht war eine russhaltige Schicht (LAMS), die Teil der Digital LUX-ITP Platte von Mac Dermid ist. Die russhaltige Schicht wurde mit einem Lasergerät des Typs Multi DX 220 der Fa. Lüscher bebildert. Danach wurde das bebilderte Aufzeichnungselement gemäss Verfahrensschritt c) von Vergleichsbeispiel V belichtet und weiter verarbeitet.

### Vergleichsbeispiel V: (gemäss EP 3 401 732 A1)

Die aufzeichnungsfähige Vorlageschicht (D) wurde auf eine dünne Folie (E1) als Trägerfolie aufgebracht und anschliessend auf die Reliefbildende Polymerschicht (B) des Flexodruckelements laminiert. (gemäss Vergleich der Erfindung EP 3401 732 A1)

Die Formulierung der aufzeichnungsfähigen Vorlageschicht (D) wurde auf eine 6 µm-PET-Folie (E1) mit einer Auftragsmenge von ca. 15 g/m² Feststoff aufgetragen und dann in einem Ofen bei einer Temperatur von 130°C während 2 Min. getrocknet. Die Zwischenfolie (C) als Vergleich zum Zwischenschichtverbund der gegenwärtigen Erfindung mit der Schicht (D) wurde mindesten 24 Stunde bei Raumtemperatur, ca. 20°C, und 50% rel. Feuchtigkeit gelagert. Aufgrund der Herstellung und Weiterverarbeitung innerhalb der gleichen Laborräumlichkeiten wurde auf Abdeckung der aufzeichnungsfähigen Vorlageschicht (D) mit einer Abdeckfolie (E2) verzichtet. Anschliessend an die Lagerung wurde die Zwischenfolie (C) mit der Schicht (D) - nach Entfernen der Schutzfolie (E3) - auf die reliefbildende Polymerschicht (B) des Flexodruckelements laminiert. Es wurde ein Aufzeichnungselement gemäss EP 3 401 732 A1 erhalten, das zur Herstellung der fertigen Flexodruckplatte bereit steht.
a) Das erhaltene Aufzeichnungselement wurde mit einem Laserbelichter des Typs Multi DX 220 der Fa. Lüscher mit einer Energie von 500 mJ/cm² bei einer Wellenlänge von 405 nm und mit 2540 dpi belichtet und
b) anschliessend in Ammoniakdampf (erzeugt aus einer alkalischen Lösung (25% Ammoniak) bei einer Temperatur von mindestens 70°C, maximal 95°C) entwickelt.
c)Danach wurde die Druckplatte mit der in Schritt b) erhaltenen Maske, bzw. der bebilderten Vorlageschicht (D), mit einem UV-Belichter des Typs Cyrel 2001 E während 50 Sek. (Sockel)/ 600 Sek.(Vorderseite) mittels UV-A-Strahlung belichtet.
d)Anschliessend wurden - nach Abziehen der Folie (C) zusammen mit der Schicht (D) - die nicht polymerisierten Bereiche der reliefbildenden Polymerschicht (B) mit nylosolv® A der Fa Flint in einem Dupont-Prozessor des Typs CYREL 3000P während 15 Min. ausgewaschen.
e)Die erhaltene Flexodruckplatte wurde während 120 Minuten bei einer Temperatur von ca. 65°C getrocknet.
f)Danach wurde die Flexodruckplatte nachbelichtet:
   Zuerst ca. 11 Minuten mit UV-C Strahlung, um die Klebrigkeit an der Oberfläche zu minimieren,
   dann ca. 10 Minuten mit UV-A Strahlung, um eine ausreichende Nachhärtung zu erreichen.

Die derart gefertigte Flexodruckplatte war bereit für den Einsatz.

### Vergleichsbeispiel VI: (gemäss EP 3 401 732 A1)

Wie Vergleichsbeispiel V aber die aufzeichnungsfähige Vorlageschicht (D) wurde auf eine dünne PET-Folie (E1), deren Dicke 12 µm ist, aufgebracht und anschliessend auf die reliefbildende Polymerschicht (B) des Flexodruckelements laminiert.

Das erhaltene Aufzeichnungselementelement zur Herstellung der fertigen Flexodruckplatte wurde gemäss Vergleichsbeispiel V bereitgestellt und die Fertigung der erhaltene Flexodruckplatte wurde dann analog Vergleichsbeispiel V, Schritte a) bis f) weiterbehandelt.

### Beispiel 1:

Die aufzeichnungsfähige Vorlageschicht wurde gemäss Erfindung mit einem Zwischenschichtverbund (C) aus Sperrschicht (C1) und haftungsmodulierende Schicht(C2) auf ein Flexodruckelement aufgebracht.

Die Formulierung der aufzeichnungsfähigen Vorlageschicht (D) wurde auf eine 100 µm-PET-Folie(E1) ohne Haftschicht mit einer Auftragsmenge von ca. 15 g/m² Feststoff aufgetragen und dann in einem Ofen bei einer Temperatur von 130°C während 2 Min. getrocknet. Anschliessend wurde die Barriereschicht (C1) auf die Schicht(D) mit einer Auftragsmenge von ca. 6 g/m² in einem 2. Schritt aufgetragen und im Ofen bei einer Temperatur von 80°C während 2 Min. getrocknet. Als Bindemittel der Barriereschicht (C1) wurde Dynapol® L210 verwendet.

Anschliessend wurde die haftungsmodulierende Schicht (C2) auf die Schicht (C1) mit einer Auftragsmenge von ca. 6 g/m² in einem 3. Schritt aufgetragen und im Ofen bei einer Temperatur von 80°C während 2 Min. getrocknet. Als Bindemittel der haftungsmodulierenden Schicht (C2) wurde Technomelt PA 6900 E verwendet.

Das derart hergestellte dreischichtige Material aus der aufzeichnungsfähigen Vorlageschicht (D) und dem für aktinische Laserstrahlung transparenten Zwischenschichtverbund (C) wurde unter gleichzeitiger Entfernung der Trägerfolie (E1) und unter Bildung des Aufzeichnungselements auf die reliefbildende Polymerschicht (B) des Flexodruckelements übertragen. Es wurde ein erfindungsgemässes Aufzeichnungselement erhalten, das zur Herstellung der fertigen Flexodruckplatte bereit steht.

Die Herstellung der Flexodruckplatte erfolgte wie in Vergleichsbeispiel V beschrieben, mit der Ausnahme, dass anstelle der Folie (C) in Schritt d) der Zwischenschichtverbund (C) abgezogen wurde.

Die derart gefertigte Flexodruckplatte war bereit für den Einsatz.

### Beispiel 2:

Die aufzeichnungsfähige Vorlageschicht wurde gemäss Erfindung mit einem Zwischenschichtverbund (C) aus Sperrschicht (C1) und haftungsmodulierende Schicht (C2) aufgebracht.

Es wurde analog Beispiel 1 vorgegangen, mit dem Unterschied dass als Bindemittel der haftungsmodulierenden Schicht (C2) anstelle von Technomelt PA 6900 E Polyvinylalkohol verwendet wurde.

### Beispiel 3:

Die aufzeichnungsfähige Vorlageschicht wurde gemäss Erfindung mit einem Zwischenschichtverbund (C) aus Sperrschicht (C1). und haftungsmodulierende Schicht (C2) aufgebracht.

Es wurde analog Beispiel 1 vorgegangen, mit dem Unterschied dass als Bindemittel der haftungsmodulierende Schicht (C2) anstelle Technomelt PA 6900 E Mowital® B 16 H verwendet wurde.

### Beispiel 4:

Die aufzeichnungsfähige Vorlageschicht wurde gemäss Erfindung mit einem Zwischenschichtverbund (C) aus Sperrschicht (C1) und haftungsmodulierende Schicht (C2) aufgebracht.

Es wurde analog Beispiel 1 vorgegangen, mit dem Unterschied dass die Auftragsmenge von Sperrschicht (C1) und haftungsmodulierende Schicht (C2) von jeweils 6.0 g/m2 auf jeweils 3.5 g/m2 reduziert wurde.

### Beispiel 5:

Die aufzeichnungsfähige Vorlageschicht wurde gemäss Erfindung mit einem Zwischenschichtverbund (C) aus Sperrschicht (C1) und haftungsmodulierende Schicht (C2) aufgebracht.

Es wurde analog Beispiel 1 vorgegangen, mit dem Unterschied dass als Bindemittel der Sperrschicht (C1) anstelle von Dynapol® L210 Vitel® 2475 verwendet wurde.

### Vergleich der Vergleichsbeispiele I bis VI und IV mit den erfindungsgemässen Beispielen 1 bis 5

### Auswertung

Die erhaltenen Flexodruckplatten wurden anhand des bebilderten UGRA/FOGRA-Digital-Plattenkeils, der unterschiedlichen bebilderten Schriftgrössen (0.5 pt. bis 8 pt.) sowie der bebilderten Punktgrössen und Linienschärfen (von 20 bis 600 µm) unter dem Mikroskop bei einer 30-fachen Vergrösserung geprüft. Folgende Merkmale wurden gewertet:
**1. *Bestimmung der Punktgrösse in µm*:** die bebilderten Punkte wurden im Mikroskop gemessen und ausgewertet und die kleinste Punktgrösse, die sichtbar und druckfähig war, wurde als Referenzwert aufgenommen.
**2. *Bestimmung der Schriftgrösse in pt*:** Die bebilderten Buchstaben auf einer Skala von 0.5 bis 6.0 pt wurden im Mikroskop ausgewertet und die kleinste Schriftgrösse, die als lesbar und scharf beurteilt wurde, wurde als Referenzwert aufgenommen.
**3. *Bestimmung der Linienbreite* µm:** Die bebilderten Linien wurden im Mikroskop gemessen und ausgewertet. Die schmalste sichtbare und für die Druckwiedergabe ausreichend scharfe Linie wurde als Referenzwert aufgenommen.
**4.** ***Bestimmung des niedrigsten und höchsten Tonwerts (%)** :* Auf dem Verlaufs-/Stufenkeil (UGRA/FOGRA-Digital-Plattenkeil) wurden die abgestuften Tonwerte von 0 bis 100% mittels Mikroskop gemessen und ausgewertet. Der kleinste und der höchste Tonwert des Verlaufs-/Stufenkeils mit ausreichendem Profil für die Druckwiedergabe wurden als Referenzwerte aufgenommen.
**5*. Bestimmung der Gleichmässigkeit vor Behandlung:*** Nach der Herstellung eines Aufzeichnungselements im A4-Format durch Laminieren eines erfindungsgemässen Halbfabrikats und einer kommerziellen Druckplatte und entfernen der Deckfolie E1 aber vor Belichten der Platte mit einem Laser und Entwickeln wurde die Anzahl von Fehlern und Unregelmässigkeiten ausgezählt.
**6. *Bestimmung der Gleichmässigkeit nach Behandlung:*** Ein analog zu Ziffer 5 hergestelltes Aufzeichnungselement im A4-Format wurde mit dem Laser belichtet, entwickelt und durch die erhaltene Maske mit UV-Licht belichtet. Die Schicht (D) mit der Folie oder dem Schichtverbund (C) wurde abgezogen. Die Platte wurde ausgewaschen. Danach wurde wieder die Anzahl der Fehler und Unregelmässigkeiten der für den Einsatz vorbereiteten Platte bestimmt, wie z.B. Abbildung der Falten, Verschiebung der Buchstaben gegenüber einem Vorlagemuster etc.

**Tabelle 1: Auswertung der Eigenschaften - Ergebnisse**

| **Beispiel** | **Punktgrösse** | **Schriftgrösse** | **Linienbreite** | **Verlaufskeil** | **Gleichmässigkeit vor Fertigung** | **Gleichmässigkeit nach Fertigung** |
|---|---|---|---|---|---|---|
| | **sichtbar ab: [µm] 1** | **lesbar ab: [pt]** | **sichtbar ab: [µm]** | **niedrigster/ höchster Tonwert [%]** | **Anzahl von Fehlern/ Unregelmässigkeiten** | **Anzahl von Fehlern / Unregelmässigkeiten** |
| | **1** | **2** | **3** | **4** | **5** | **6** |
| **Vgl. I** | 100 | 1 | 40 | 3.0 / 95.0 | 0 | 0 |
| **Vgl. II** | 100 | 1 (zerfranst) | 50 | 3.0 / 97.0 | 0 | 0 |
| **Vgl. III** | 500 | 2 (zerfranst) | 100 | 4.0 / 94.0 | 0 | 0 |
| **Vgl. IV** | 75 | 1 | 50 | 1.0 / 97.0 | 0 | 0 |
| **Vgl. V** | 40 | 0.5 | 20 | 1.0 / 97.0 | 22 | 33 |
| **Vgl. VI** | 50 | 1 | 40 | 1.0 / 97.0 | 12 | 21 |
| **1** | 30 | 0.5 | 20 | 1.0 / 98.0 | 0 | 0 |
| **2** | 30 | 0.5 | 20 | 1.0 / 98.0 | 0 | 0 |
| **3** | 30 | 0.5 | 20 | 1.0 / 98.0 | 0 | 0 |
| **4** | 20 | 0.5 | 20 | 1.0 / 99.0 | 0 | 0 |
| **5** | 30 | 0.5 | 20 | 1.0 / 98.0 | 0 | 0 |

Die Versuche **1** bis **5** gemäss Tabelle 1 belegen, dass die erfindungsgemässen Aufzeichnungselemente eine hohe Auflösung besitzen, sehr feine und fehlerfreien Oberflächenstrukturen abbilden können, einfacher verarbeitbar bei der Fertigung sind und insgesamt eindeutig den Stand der Technik übertreffen.

Während in der vorliegenden Anmeldung bevorzugte Ausführungen der Erfindung beschrieben sind, ist klar darauf hinzuweisen, dass die Erfindung nicht auf diese beschränkt ist und auch in anderer Weise innerhalb des Umfangs der folgenden Ansprüche ausgeführt werden kann.

## Patentansprüche

1. Aufzeichnungselement, das zur Herstellung von hochauflösenden Flexodruckplatten durch digitale Informationsübertragung geeignet und mit aktinischer Laserstrahlung bebilderbar oder bebildert ist und welches in der genannten Reihenfolge übereinander angeordnet die folgenden Schichten enthält oder daraus besteht:
**(A)** eine Trägerfolie, die optional auf der mit einer fotopolymeriserbaren Schicht/reliefbildende Polymerschicht versehenen Seite mit einer Haftschicht versehen sein kann,
**(B)** eine in organischen und/oder wässerigen Lösemitteln lösliche und/oder durch thermische Verfahren schmelzbare und/oder flüchtige fotopolymerisierbare Schicht/reliefbildende Polymerschicht, die durch aktinische Strahlung vernetzbar ist,
**(C)** einen für aktinische Strahlung transparenten Zwischenschichtverbund, der aus mindestens 2 übereinander liegenden polymerhaltigen Verbundschichten besteht, wobei eine zweite Verbundschicht (C2) eine auf der Reliefschicht angeordnete haftungsmodulierende Schicht ist und eine erste Verbundschicht (C1) eine zwischen der zweiten Verbundschicht (C2) und der aufzeichnungsfähigen Vorlageschicht (D) angeordnete Sperr- oder Barriereschicht gegenüber den in der aufzeichnungsfähigen Vorlageschicht (D) enthaltenen Diazonium-Verbindungen ist.
**(D)** eine aufzeichnungsfähige Vorlageschicht umfassend eine monomere Diazonium-Verbindung, die gegen aktinische Laserstrahlung lichtempfindlich ist und durch Entwickeln eine Änderung in der aktinischen Dichte erfährt oder eine bebilderte Vorlageschicht, in der die monomere Diazonium-Verbindung in mindestens einem Bereich durch aktinische Laserstrahlung zerstört ist und in mindestens einem nicht belichteten Bereich infolge Entwickelns eine erhöhte aktinische Dichte hat..
**(E1)** gegebenenfalls eine abziehbare Schutz- oder Deckfolie.

2. Das Aufzeichnungselement gemäss Anspruch 1, **dadurch gekennzeichnet, dass** der für aktinische Strahlung transparente Zwischenschichtschichtverbund **(C)** eine Dicke von bis zu 100 µm, wie 0.1 µm bis 100 µm, vorzugsweise von 0.2 µm bis 50 µm, insbesondere von 0.4 µm bis 30 µm, speziell bevorzugt von 0.6 µm bis 20 µm, aufweist, wobei die zweite Verbundschicht **(C2)** des Zwischenschichtverbunds **(C)** eine Dicke von bis zu 50 µm, wie von 0.05 µm bis 50 µm vorzugsweise von 0.1 µm bis 25 µm, insbesondere von 0.2 µm bis 15 µm, speziell bevorzugt von 0.3 µm bis 10 µm aufweist und/oder
die erste Verbundschicht **(C1)** des Zwischenschichtverbunds **(C)** eine Dicke von bis zu 50 µm, wie von 0.05 µm bis 50 µm vorzugsweise von 0.1 µm bis 25 µm, insbesondere von 0.2 µm bis 15 µm, speziell bevorzugt von 0.3 µm bis 10 µm aufweist.

3. Das Aufzeichnungselement gemäss einem der vorangehenden Ansprüche, **dadurch gekennzeichnet, dass**
die zweite Verbundschicht **(C2)** des Zwischenschichtverbunds(C) eine Schälkraft zur reliefbildenden Polymerschicht (B) von 0.01 N/m bis 200 N/m, vorzugsweise von 0.05 N/m bis 150 N/m, insbesondere von 0.1 N/m bis 100 N/m, speziell bevorzugt von 0.2 N/m bis 50 N/m, und
eine Dehnung von 50 bis 1500%, vorzugsweise von 100 bis 1200%, insbesondere von 200 bis 1000%, speziell bevorzugt von 300 bis 800%, aufweist.

4. Das Aufzeichnungselement gemäss einem der vorangehenden Ansprüche, **dadurch gekennzeichnet, dass**
die erste Verbundschicht (C1) zu mind. 70 Gew.-%, vorzugsweise zu mind. 85 Gew.-% aus mindestens einem Bindemittel besteht, welches auf mindestens einem in Wasser und/oder organischem Lösungsmittel löslichen Polymer oder Copolymer basiert und eine Sauerstoffdurchlässigkeit von unter 1000 (cm³ x 100µm) / (m² x d x bar) und bevorzugt kleiner als 500 (cm³ x 100µm) / (m² x d x bar) aufweist,
die zweite Verbundschicht (C2) zu mind. 70 Gew.-%, vorzugsweise zu mind. 85 Gew.-% aus mindestens einem Bindemittel besteht, welches auf mindestens einem in Wasser und/oder organischem Lösungsmittel löslichen und weichelastischen und/oder thermoplastischen Polymer oder Copolymer basiert.

5. Das Aufzeichnungselement gemäss einem der vorangehenden Ansprüche, **dadurch gekennzeichnet, dass**
das Bindemittel der ersten Verbundschicht (C1) ausgewählt ist aus
Polyester, wie Polyethylenterephthalat (PET), Polybutylenterephthalat (PBT), Polyethylennaphthalat (PEN),
Polymethacrylate, wie Polymethylmethacrylat (PMMA),
Polymilchsäuren (PLA),
Polycarbonate,
Polyamide (PA),
nicht-halogenierte oder halogenierte Polyolefine, wie Polyethylen (PE), Polypropylen (PP), Polymethylpenten (PMP) und Polybutylen (PB, PIB) oder Fluorpolymere, wie Tetrafluorethylen (PTFE), Polyvinylidenchlorid (PVDC), Polyvinylidenfluorid (PVDF), Ethylen-Tetrafluorethylen (ETFE), Polyvinylfluorid (PVF),Perfluorethylenpropylen (PEP, FEP),
Polyarylsufone, wie Polysulfon (PSU) und Polyethersulfon (PES),
Polymere des Vinylalkohols, wie Polyvinylalkohol, Polyvinylacetat (PVA, PVAC), Ethylenvinylacetat-Copolymer (EVAC), Ethylen-vinylalkohol-Copolymer (EVOH) und
Mischung derselben, insbesondere
gesättigte und ungesättigte Copolyester, wie Polyethylenterephtalat (PET), Polybutylenterephtalat (PBT), Polyethylennaphthalat (PEN), Polymethylmethacrylat (PMMA), Polymilchsäuren (PLA) und Mischung derselben, alle mit einem Molekulargewicht über 1000 und
das Bindemittel der zweiten Verbundschicht (C2) ausgewählt ist aus
Polyvinylalkohole,
teil- oder hochverseifte Polyvinylcarboxylate,
Polyvinylacetate, Poly(ethylenoxid-vinylalcohol)-Copolymere , Polyvinylbutyral,
Polyamide,
Polyurethane,
Polyvinylpyrrolidon,
(Silicon-Polyurethan)-Copolymere,
Polyethylenvinylacetat,
Polyolefine,
Polystyrol Homo- oder Copolymere,
Gelatine und
Mischung derselben, insbesondere
Polyvinylalkohol, Polyvinypyrrolidon, Polyamid, Polyurethan, (Silicon-Polyurethan)-Copolymere, Gelatine und Mischung derselben.

6. Das Aufzeichnungselement gemäss einem der vorangehenden Ansprüche, **dadurch gekennzeichnet, dass** die aufzeichnungsfähige Vorlageschicht (D) eine Schichtdicke von 1 µm bis 50 µm, vorzugsweise von 3 µm bis 30 µm, aufweist und/oder mit aktinischer Laserstrahlung einer Leistung von 10 bis 1500 mJ/cm² im Spektralbereich von 330 nm bis 430 nm, insbesondere von 50 bis 1000 mJ/cm² im angegebenen Spektralbereich, belichtbar ist.

7. Das Aufzeichnungselement gemäss einem der vorangehenden Ansprüche, **dadurch gekennzeichnet, dass** die aufzeichnungsfähige Vorlageschicht mittels einer alkalischen Lösung oder alkalischer Dämpfe, wie Ammoniakdampf, entwickelt werden kann, derart, dass die unbelichteten Bereiche für aktinische Strahlung weniger durchlässig werden, insbesondere derart, dass die nicht belichteten, entwickelten Bereiche der aufzeichnungsfähige Vorlageschicht eine aktinische Dichte > 3.0 aufweisen.

8. Das Aufzeichnungselement gemäss einem der vorangehenden Ansprüche, **dadurch gekennzeichnet, dass** die aufzeichnungsfähige Vorlageschicht zu mindestens 70 Gew.-%, insbesondere zu mind. 85 Gew.-% aus einem Gemisch aus mindesten einem auf Celluloseester basierten Bindemittel und einer Diazoniumverbindung und einer reaktiven Kuppler-Verbindung besteht, wobei
die Diazoniumverbindung ein Diazoniumsalz gemäss Formel **(I)** ist,
**R-N≡N⁺X⁻** **(I)**
worin **R** eine substituierte oder unsubstituierte organische Gruppe wie eine Alkyl-, Acyl-, oder aromatische Gruppe bedeutet und
**X⁻** ein Anion ist, insbesondereausgewählt aus der Gruppe umfassend BF₄⁻, AsF₆⁻, ClO₄⁻, SbF₆⁻, CF₃SO₃⁻, SO₄⁻, PF₆⁻ PO₄³⁻, NO₃⁻, Br⁻, Cl⁻, I⁻, F⁻, Arylsulfonat, wie p-Chlorbenzolsulfonat, Alkylsulfonat, Allylsulfonat, oder ein Metallkomplexanion, z.B. ZnCl₃⁻, SnCl₆²⁻
und die reaktive Kuppler-Verbindung, insbesondere einer Kupplerverbindung der Formel **(II)** ist, 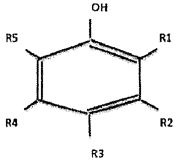 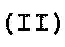
worin **R1, R2, R3, R4 und R5** gleich oder verschieden sein können und ausgewählt sind aus der Gruppe umfassend -OH, -SO₃H, -CONH-R6 (R6=Alkyl-, Aryl-, Cycloalkyl, Alkoxy), Alkoxygruppe, Carboxygruppe, Guanidingruppe, Aminogruppe, Acylamidogruppe, Thioharnstoffgruppe, Thiogruppe, Wasserstoff oder Halogen, oder
**R1 und R2** oder **R2 und R3** zusammen einen Butadienylrest bilden,
und worin das Verhältnis von Bindemittel zu Diazoverbindung üblicherweise von 50 : 1 bis 1 : 2, vorzugsweise 20 : 1 bis 1 : 1 beträgt und das Verhältnis von Diazoverbindung zu Kupplerverbindung von 4 : 1 bis 1 : 4, vorzugsweise 2 : 1 bis 1 : 2 ist.

9. Das Aufzeichnungselement gemäss einem der vorangehenden Ansprüche, **dadurch gekennzeichnet, dass** die reliefbildende Polymerschicht **(B)** eine Schichtdicke von 200 µm bis 8000 µm, insbesondere 300 µm bis 6000 µm, aufweist und/oder mindestens ein elastomeres Bindemittel, mindestens zwei ethylenisch ungesättigte copolymerisierbare organische Verbindung (Monomere) und mindestens einen Fotoinitiator oder ein Fotoinitiatorsystem enthält oder daraus besteht.

10. Halbfabrikat zur Herstellung eines Aufzeichnungselements gemäss einem der Ansprüche 1 bis 9, **dadurch gekennzeichnet, dass** es die folgenden Schichten enthält oder daraus besteht:
(E1) eine abziehbare Schutz- oder Deckfolie, die auch als Träger dient,
(D) eine aufzeichnungsfähige Vorlageschicht umfassend eine monomere Diazonium-Verbindung, die gegen aktinische Laserstrahlung lichtempfindlich ist und durch Entwickeln eine Änderung in der aktinischen Dichte erfährt,
(C) einen für aktinische Strahlung transparente Zwischenschichtverbund, der aus mindestens 2 aufeinander liegenden polymerhaltigen Verbundschichten besteht, wobei eine zweite Verbundschicht (C2) eine auf der Reliefschicht angeordnete haftungsmodulierende Schicht ist und eine erste Verbundschicht (C1) eine zwischen der zweiten Verbundschicht (C2) und der aufzeichnungsfähigen Vorlageschicht (D) angeordnete Sperrschicht gegenüber den in der aufzeichnungsfähigen Vorlageschicht (D) enthaltenen Diazonium-Verbindungen ist,
(E2) gegebenenfalls und vorzugsweise eine Schutzfolie.

11. Verfahren zur Herstellung eines Halbfabrikats gemäss Anspruch 10, **dadurch gekennzeichnet, dass** es die folgenden Schritte umfasst:
(iii) Bereitstellen einer Schutz- oder Trägerfolie (E1)
(ii) einseitiges Auftragen und Trocknen einer Formulierung für die aufzeichnungsfähige Vorlageschicht (D)
(iv) Auftragen und Trocknen einer Formulierung für eine Barriereschicht (C1) auf die Schicht (D),
(iv) Auftragen und Trocknen einer Formulierung für eine haftungsmodulierende Schicht (C2) auf die Barriereschicht (C1),
(v) gegebenenfalls Aufbringen einer Schutzschicht (E2) auf die haftungsmodulierende Schicht (C2) .

12. Verfahren zur Herstellung eines Aufzeichnungselements gemäss einem der Ansprüche 1 bis, unter Verwendung eines Halbfabrikats gemäss Anspruch 10 und eines Flexodruckelements umfassend eine Trägerfolie **(A),** eine reliefbildende Polymerschicht **(B),** gegebenenfalls eine Haftschicht zwischen der reliefbildende Polymerschicht **(B)** und der Trägerfolie **(A)** und gegebenenfalls eine abziehbare Schutz- oder Deckfolie **(E3)** auf der reliefbildenden Polymerschicht **(B), dadurch gekennzeichnet, dass** es die folgenden Schritte umfasst:
(i) **Entfernen** gegebenenfalls vorhandener Schutz- oder Deckfolien **(E2), (E3)** von der für aktinische Strahlung transparenten Zwischenschichtverbund **(C)** und von der reliefbildende Polymerschicht **(B)** des Flexodruckelements,
(ii) **Transferieren und laminieren** der Folie **(E1)** auf der aufzeichnungsfähigen Vorlageschicht **(D)** und auf dem für aktinische Strahlung transparenten Zwischenschichtverbund **(C)** mit dem Zwischenschichtverbund **(C)** auf die reliefbildende Polymerschicht **(B)** des Flexodruckelements.

13. Verfahren zur Herstellung hochauflösender Flexodruckplatten unter Verwendung eines Aufzeichnungselements gemäss einem der Ansprüche 1 bis 9 und Bebilderung mittels digitaler Informationsübertragung unter Verwendung aktinischer Laserstrahlung, **dadurch gekennzeichnet, dass** es die folgenden Verfahrensschritte umfasst:
**(1) Abziehen** der Deckfolie **(E1),**
**(2) Belichten** der aufzeichnungsfähigen Vorlageschicht **(D)** mittels aktinischer Laserstrahlung, insbesondere mit aktinischer Laserstrahlung von 10 bis 1500 mJ/cm² im Spektralbereich von 330 nm bis 430 nm, insbesondere von 50 bis 1000 mJ/cm² im angegebenen Spektralbereich, unter Bildung einer belichteten Vorlageschicht,
**(3) Entwickeln** der belichteten Vorlageschicht unter Bildung einer bebilderten Vorlageschicht **(D),** insbesondere Entwickeln unter Verwendung einer alkalischen Lösung oder eines alkalischen Dampfes, insbesondere Ammoniakdampf,
**(4) Belichten** des mit der bebilderten Vorlageschicht **(D)** versehenen Aufzeichnungselements mit aktinischer Strahlung durch die bebilderte Vorlageschicht **(D)** hindurch, insbesondere mit aktinischer Strahlung von >5 bis 100 J/cm² im Spektralbereich von 200 nm bis 450 nm ,
**(5) Entfernen** der Vorlageschicht **(D),** und der vorhandenen Zwischenschichtverbund **(C)** sowie der nicht polymerisierten Anteile der reliefbildenden Schicht **(B)** unter Bildung der Flexodruckplatte,
**(6) Trocknen** der erhaltenen Flexodruckplatte und
**(7)** gegebenenfalls und vorzugsweise **Nachbehandeln** der Flexodruckplatte mit UV-Licht.

14. Verfahren gemäss Anspruch 13, **dadurch gekennzeichnet, dass** der Zwischenschichtverbund **(C)** zusammen mit der Vorlageschicht **(D)** abgezogen und die nicht polymerisierten Teile der reliefbildenden Polymerschicht **(B)**
- mittels eines Auswaschmittels, welches Wasser und/oder Lösungsmittel enthält oder daraus besteht, und/oder
- mittels eines thermischen Verfahren, welches Schmelzen und Verdunsten durch Erwärmen oder Erhitzen erzielt, entfernt werden.
